# FASCICULE DE BREVET EUROPEEN

(11) **EP 4 391 082 B1**
(45) Date de publication et mention de la délivrance du brevet: **01.04.2026**
(21) Numéro de dépôt: 23219606.3
(22) Date de dépôt: 22.12.2023
(51) Int. Cl.: H10D 30/01, H10D 30/67, G06N 10/40

(54) **PROCÉDÉ DE RÉALISATION D'UN DISPOSITIF SEMI-CONDUCTEUR COMPRENANT UNE GRILLE ARRIÈRE**
VERFAHREN ZUR HERSTELLUNG EINER HALBLEITERANORDNUNG MIT EINEM RÜCKGITTER
METHOD OF MANUFACTURING A SEMICONDUCTOR DEVICE COMPRISING A BACK GATE

(30) Priorité: 23.12.2022 FR 2214382
(43) Date de publication de la demande: 26.06.2024
(73) Titulaire: Commissariat à l'Energie Atomique et aux Energies Alternatives, 75015 Paris (FR)
(72) Inventeur: NIEBOJEWSKI, Heimanu, 38054 Grenoble Cedex 09 (FR); BEDECARRATS, Thomas, 38054 Grenoble Cedex 09 (FR); BERTRAND, Benoit, 38054 Grenoble Cedex 09 (FR)
(74) Mandataire: Hautier IP

(56) Documents cités:
- FR-A1- 2 952 472

## Description

### DOMAINE TECHNIQUE

La présente invention concerne le domaine de la microélectronique et de l'électronique quantique en particulier. Elle trouve par exemple pour application particulièrement avantageuse la réalisation de grilles arrières dans des dispositifs quantiques à bits quantiques (appelés quantum bits ou qubits), notamment pour des dispositifs basés sur des architectures à qubits de spin ou à qubits supraconducteurs.

### ETAT DE LA TECHNIQUE

Les dispositifs semi-conducteur, par exemple des transistors, intégrés sur un substrat de type semi-conducteur sur isolant (« Silicon on insulator » en anglais, SOI) présentent généralement de meilleures performances que les dispositifs semi-conducteur intégrés sur un substrat massif (« Bulk »), notamment en terme de consommation. Pour améliorer le contrôle électrostatique de ces dispositifs semi-conducteur intégrés sur SOI, une grille arrière conductrice peut être formée sous la couche d'isolant enterrée, de préférence à l'aplomb de la zone active du dispositif semi-conducteur qui est formée dans la couche semi-conductrice superficielle située sur la couche d'isolant enterrée. Un contact électrique sur cette grille arrière permet d'appliquer une tension variable à la grille arrière et de moduler ainsi l'environnement électrostatique au niveau de la zone active du dispositif semi-conducteur.

Pour des applications quantiques en particulier, cette tension de grille arrière est un paramètre supplémentaire très utile pour moduler l'environnement électrostatique des points quantiques.

Pour réaliser cette grille arrière conductrice, les procédés « face arrière » sont complexes et invasifs, et peu adaptés à l'échelle d'une plaque entière (« wafer »). Alternativement, les procédés d'implantation ionique en face avant, qui permettent de doper très fortement le substrat sous la couche d'isolant enterrée, induisent des dopants résiduels dans la couche semi-conductrice superficielle. Ces dopants résiduels ne sont en particulier pas compatibles avec le fonctionnement de points quantiques.

Le document FR2952472A1 décrit un exemple de procédé de réalisation d'une grille arrière sous un dispositif semi-conducteur sur SOI. Dans cet exemple, chaque dispositif est isolé électriquement par des tranchées d'isolation traversant la couche semi-conductrice superficielle et la couche d'isolant enterrée, et s'étendant jusqu'au substrat. Le procédé consiste à former une ouverture au sein d'une tranchée d'isolation par gravure anisotrope, puis étendre cette ouverture par gravure isotrope de sorte à ce que l'ouverture débouche dans la couche d'isolant enterrée, sous la couche semi-conductrice superficielle. Un retrait du matériau de la couche d'isolant enterrée, sélectivement aux matériaux du substrat, de la couche semi-conductrice superficielle et des tranchées d'isolation, est alors effectué à travers l'ouverture. Une cavité est ainsi formée sous le dispositif semi-conducteur. La cavité est ensuite remplie par un matériau conducteur de sorte à former la grille arrière conductrice sous le dispositif semi-conducteur. L'ouverture est également remplie par le matériau conducteur et forme ainsi un contact électrique pour la grille arrière. Un inconvénient de ce procédé est que l'ouverture pratiquée au sein de la tranchée d'isolation est relativement large, ce qui limite la densité d'intégration des dispositifs. La largeur minimale à prévoir pour ces tranchées d'isolation doit être relativement élevée pour permettre la formation d'une grille arrière localement, sous un dispositif individuel, sans impacter l'intégrité d'un dispositif voisin.

Il subsiste donc un besoin de disposer d'un procédé de réalisation d'une grille arrière sous un dispositif semi-conducteur sur SOI permettant une densité d'intégration plus grande. Un objectif de l'invention est de répondre à ce besoin, et de pallier au moins en partie les inconvénients des solutions connues.

En particulier, un objet de l'invention est un procédé de réalisation d'une grille arrière sous un dispositif semi-conducteur sur SOI permettant d'augmenter la densité d'intégration. Un autre objet de l'invention est un dispositif issu d'un tel procédé de réalisation.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon la revendication 1 on prévoit un procédé de réalisation d'une grille arrière sous un dispositif semi-conducteur, ledit dispositif semi-conducteur étant formé sur ou à partir d'une couche semi-conductrice d'un empilement comprenant successivement une couche de support, une couche sacrificielle et la couche semi-conductrice.

Le procédé comprend :
- une formation de tranchées d'isolation autour du dispositif semi-conducteur, lesdites tranchées d'isolation traversant la couche semi-conductrice superficielle et la couche sacrificielle, et s'étendant jusqu'à la couche de support,
- une gravure partielle des tranchées d'isolation de sorte à former une ouverture débouchant sur la couche sacrificielle,
- un retrait de la couche sacrificielle sélectivement à la couche semi-conductrice, à la couche de support et aux tranchées d'isolation, de sorte à former une cavité sous le dispositif semi-conducteur,
- un remplissage de la cavité par un matériau électriquement conducteur de sorte à former la grille arrière sous le dispositif semi-conducteur.

La formation des tranchées d'isolation comprend :
- une première gravure configurée pour former au moins un motif de tranchée présentant un fond et des flancs,
- une formation d'une couche de revêtement sacrificielle au moins sur les flancs de l'au moins un motif de tranchée, en contact avec la couche sacrificielle de l'empilement, puis
- un remplissage de l'au moins un motif de tranchée par un matériau isolant, configuré de sorte que ledit matériau isolant s'étende au moins jusqu'au sein de la couche sacrificielle de l'empilement, et de préférence jusqu'au sein de la couche de support de l'empilement.

La gravure partielle des tranchées d'isolation comprend :
- un retrait de la couche de revêtement sacrificielle sélectivement au matériau isolant.

Ainsi, seule une partie localisée sur les flancs du motif de tranchée est gravée lors de la gravure partielle de la tranchée d'isolation. Cela permet de confiner la gravure partielle entre le flanc du motif de tranchée et le matériau isolant de remplissage de la tranchée d'isolation.

Contrairement à la solution divulguée par le document FR 2952472 A1 dans laquelle la gravure partielle de la tranchée d'isolation n'est pas confinée, le dimensionnement de la tranchée d'isolation est ainsi mieux maîtrisé. Cela permet d'augmenter la densité d'intégration des dispositifs semi-conducteurs.

Il est en outre possible d'effectuer une gravure partielle de la tranchée d'isolation au niveau d'un seul flanc du motif de tranchée. Cela permet d'accéder à une couche sacrificielle située du côté de ce flanc uniquement, en préservant l'autre flanc du motif de tranchée. Différents dispositifs semi-conducteurs peuvent ainsi être co-intégrés densément et facilement. En particulier, un dispositif semi-conducteur comprenant une grille arrière peut être formé directement au voisinage d'un dispositif semi-conducteur sans grille arrière, sans qu'il soit nécessaire d'augmenter la largeur de la tranchée d'isolation les séparant l'un de l'autre, contrairement à la solution divulguée par le document FR 2952472 A1. Le procédé selon l'invention offre ainsi une solution améliorée pour la réalisation de grilles arrière localisées sous un ou plusieurs dispositifs semi-conducteurs, avec une densité d'intégration augmentée.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A, 2A, 3A, 4A, 5A, 6A, 7A, 8A, 9A, 10A, 11A, 12A, 13A, 14A, 15A, 16A, 17A illustrent schématiquement en coupe transverse des étapes de fabrication d'une grille arrière sous un dispositif semi-conducteur, selon un mode de réalisation de la présente invention.
Les figures 1B, 2B, 3B, 4B, 5B, 6B, 7B, 8B, 9B, 10B, 11B, 12B, 13B, 14B, 15B, 16B, 17B illustrent schématiquement en vue de dessus les étapes de fabrication illustrées aux figures 1A, 2A, 3A, 4A, 5A, 6A, 7A, 8A, 9A, 10A, 11A, 12A, 13A, 14A, 15A, 16A, 17A correspondantes, selon un mode de réalisation de la présente invention.
Les figures 4C, 4D, 4E illustrent schématiquement en coupe transverse des étapes de fabrication d'une tranchée d'isolation, selon un autre mode de réalisation de la présente invention.
La figure 17C illustre schématiquement en coupe transverse un dispositif semi-conducteur comprenant une grille arrière, adjacent à un autre dispositif semi-conducteur sans grille arrière, selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs et/ou les dimensions des différentes couches, motifs et reliefs ne sont pas représentatives de la réalité. Pour des raisons de clarté, l'ensemble des références alphanumériques n'est pas systématiquement repris d'une figure à l'autre. Il est entendu que les éléments déjà décrits et référencés, lorsqu'ils sont reproduits sur une autre figure, portent typiquement les mêmes références alphanumériques, même si celles-ci ne sont pas explicitement mentionnées. L'homme du métier identifiera sans difficultés un même élément reproduit sur différentes figures.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le dispositif semi-conducteur est un dispositif quantique et le matériau électriquement conducteur est métallique. Un matériau conducteur métallique permet d'obtenir une grille arrière fonctionnelle même à basse température, typiquement pour des températures de fonctionnement d'un dispositif quantique. Contrairement à un matériau conducteur de type semi-conducteur dopé ou fortement dopé, un matériau métallique n'est pas sensible au gel des porteurs qui survient à basse température. La grille arrière métallique reste ainsi fonctionnelle à basse température.

Selon un exemple, le dispositif semi-conducteur est adjacent à un deuxième dispositif semi-conducteur séparé du dispositif semi-conducteur par une tranchée d'isolation présentant un premier flanc du côté du dispositif semi-conducteur et un deuxième flanc du côté du deuxième dispositif semi-conducteur, ladite tranchée d'isolation comprenant une première portion de couche de revêtement sacrificielle sur le premier flanc et une deuxième portion de couche de revêtement sacrificielle sur le deuxième flanc.

Selon un exemple, la gravure partielle de ladite tranchée d'isolation comprend un retrait simultané des première et deuxième portions de couche de revêtement sacrificielle, de sorte à former une première grille arrière sous le dispositif semi-conducteur et une deuxième grille arrière sous le deuxième dispositif semi-conducteur. Le procédé permet ainsi de former simultanément plusieurs grilles arrière pour des dispositifs adjacents, en conservant une tranchée d'isolation fonctionnelle entre les dispositifs adjacents, grâce au matériau isolant intercalé entre les première et deuxième portions de couche de revêtement sacrificielle dans la tranchée d'isolation.

Selon un exemple alternatif, la gravure partielle de ladite tranchée d'isolation comprend un retrait de la première portion de couche de revêtement sacrificielle uniquement, sans retrait de la deuxième portion de couche de revêtement sacrificielle, de sorte à former la grille arrière uniquement sous le dispositif semi-conducteur, en conservant une portion de couche sacrificielle sous le deuxième dispositif semi-conducteur. Le procédé permet ainsi de former une grille arrière pour un seul des dispositifs adjacents, en conservant une tranchée d'isolation fonctionnelle entre les dispositifs adjacents, grâce au matériau isolant et à la deuxième portion de couche de revêtement sacrificielle dans la tranchée d'isolation.

Selon un exemple, la formation de la couche de revêtement sacrificielle se fait par dépôt conforme sur les flancs et le fond de l'au moins un motif de tranchée.

Selon un exemple, le retrait de la couche de revêtement sacrificielle est uniquement partiel et configuré pour conserver une portion de la couche de revêtement sacrificielle située sur le fond de l'au moins un motif de tranchée. Le nombre d'étapes du procédé de formation de la tranchée d'isolation et des ouvertures vers la couche sacrificielle est ainsi limité.

Selon un exemple, la formation de la couche de revêtement sacrificielle comprend un dépôt conforme sur les flancs et le fond de l'au moins un motif de tranchée, suivi d'une gravure anisotrope configurée pour retirer une portion de la couche de revêtement sacrificielle située sur le fond de l'au moins un motif de tranchée, de sorte que la couche de revêtement sacrificielle couvre uniquement les flancs de l'au moins un motif de tranchée, avant remplissage de l'au moins un motif de tranchée par le matériau isolant. Selon un exemple, le retrait de la couche de revêtement sacrificielle est total. La formation des ouvertures vers la couche sacrificielle est ainsi facilitée. Il n'est pas nécessaire de contrôler précisément l'arrêt de gravure lors du retrait de la couche de revêtement sacrificielle.

Selon un exemple, la couche de revêtement sacrificielle est choisie à base d'un premier matériau diélectrique, par exemple SiN ou SiC. Cela permet de conserver des portions de couche de revêtement sacrificielle dans la tranchée d'isolation sans affaiblir ou compromettre la fonction d'isolation de la tranchée d'isolation.

Selon un exemple, la formation de la couche de revêtement sacrificielle est configurée de sorte que la couche de revêtement sacrificielle présente une épaisseur e₁₅ selon une direction transverse aux flancs de l'au moins un motif de tranchée, et le remplissage de l'au moins un motif de tranchée par le matériau isolant est configuré de sorte que le matériau isolant présente une épaisseur e16 selon ladite direction transverse, telles que e₁₅ < e₁₆/3. Cela permet de dimensionner la tranchée d'isolation selon des proportions équilibrant la fonction d'isolation par le matériau isolant et la fonction d'accès à la couche sacrificielle de l'empilement par la couche de revêtement sacrificielle. L'isolation entre dispositifs adjacents et l'accès à la couche sacrificielle de l'empilement sont ainsi optimisés.

Selon un exemple, le procédé comprend en outre, après retrait de la couche sacrificielle et avant remplissage de la cavité par un matériau électriquement conducteur, un dépôt conforme d'une couche en un deuxième matériau diélectrique sur des parois exposées de la cavité, par exemple par dépôt chimique en phase vapeur (CVD). Cela permet d'isoler la grille arrière vis-à-vis de la couche de support et/ou vis-à-vis de la couche semi-conductrice superficielle.

Selon un exemple, la couche en un deuxième matériau diélectrique présente une épaisseur e₅₁, la couche de revêtement sacrificielle présente une épaisseur e₁₅, le matériau électriquement conducteur présente une épaisseur e₅, telles que e₅₁ < e₁₅/3 et e₅₁ < e₅/3, et de préférence telles que e₅₁ < e₁₅/4 et e₅₁ < e₅/4. Cela permet de dimensionner la grille arrière et le via de contact sur cette grille arrière selon des proportions équilibrées. La polarisation de la grille arrière et l'isolation de la grille arrière vis-à-vis de la couche de support et/ou vis-à-vis de la couche semi-conductrice superficielle sont ainsi optimisées.

Selon un exemple, le matériau isolant des tranchés d'isolation est choisi à base de SiO2. Le matériau isolant des tranchés d'isolation est différent du premier matériau diélectrique de la couche de revêtement sacrificielle.

Selon un exemple, le premier matériau diélectrique de la couche de revêtement sacrificielle présente vis-à-vis du matériau isolant des tranchés d'isolation une sélectivité à la gravure S ≥ 5:1.

Selon un exemple, la couche sacrificielle est formée sur la couche de support par épitaxie, ladite couche sacrificielle étant par exemple à base de SiGe.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention.

L'invention porte d'une manière générale sur un procédé de fabrication d'une grille arrière pour un dispositif semi-conducteur, et sur un tel dispositif équipé d'une grille arrière. Cette grille arrière peut également être désignée électrode arrière. Un dispositif semi-conducteur selon l'invention comprend typiquement une couche semi-conductrice dans laquelle transitent et/ou sont confinés des porteurs de charge ou des états quantiques. Par exemple et de façon non limitative, cette couche semi-conductrice peut ainsi former un canal de transistor, ou s'intégrer dans une architecture à qubits de spin pour des dispositifs quantiques à bits quantiques (appelés quantum bits ou qubits).

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

**On entend** par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée S_{A:B}. Une sélectivité S_{A:B} de 10:1 signifie que la vitesse de gravure du matériau A est 10 fois supérieure à la vitesse de gravure du matériau B.

On entend par « s'étendre au sein » d'une couche le fait de pénétrer dans cette couche, directement ou indirectement. **En** particulier, une structure ou un matériau s'étendant au sein d'une couche signifie que la structure ou le matériau se prolongent entre les deux faces définissant ladite couche, typiquement entre les deux faces supérieure et inférieure. Ainsi, un matériau de remplissage qui s'étend au moins jusqu'au sein de la couche sacrificielle de l'empilement signifie que le matériau de remplissage présente une portion ou une face inférieure située entre les plans définis par les faces supérieure et inférieure de la couche sacrificielle de l'empilement. Un matériau de remplissage qui s'étend au moins jusqu'au sein de la couche de support de l'empilement signifie que le matériau de remplissage présente une portion ou une face inférieure située entre les plans définis par les faces supérieure et inférieure de la couche de support de l'empilement. **En** l'occurrence, un matériau de remplissage s'étendant jusqu'au sein de la couche de **support traverse** totalement la couche sacrificielle de l'empilement. Cela permet de faciliter l'isolation entre deux dispositifs adjacents lors de la gravure de la couche de revêtement sacrificielle suivie du remplissage de la cavité par un matériau électriquement conducteur pour former la ou les grilles arrière sous l'un et/ou l'autre des dispositifs adjacents. La tolérance sur l'arrêt de la gravure de la couche de revêtement sacrificielle est augmentée.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche superficielle de silicium épitaxié présente typiquement une épaisseur selon z. Un motif de grille formé sur une telle couche superficielle présente une hauteur selon z. Les termes relatifs « sur », « surmonte », « sous », « sous-jacent » se réfèrent à des positions prises selon la direction z. Une dimension « latérale » correspond à une dimension selon une direction du plan xy. On entend par une extension « latérale » ou « latéralement », une extension selon une ou des directions du plan xy. Les épaisseurs e₁₅, e₁₆, e₅₁, e₅, etc des différentes couches sont bien entendu strictement positives.

Un élément situé « à l'aplomb » ou « au droit » d'un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

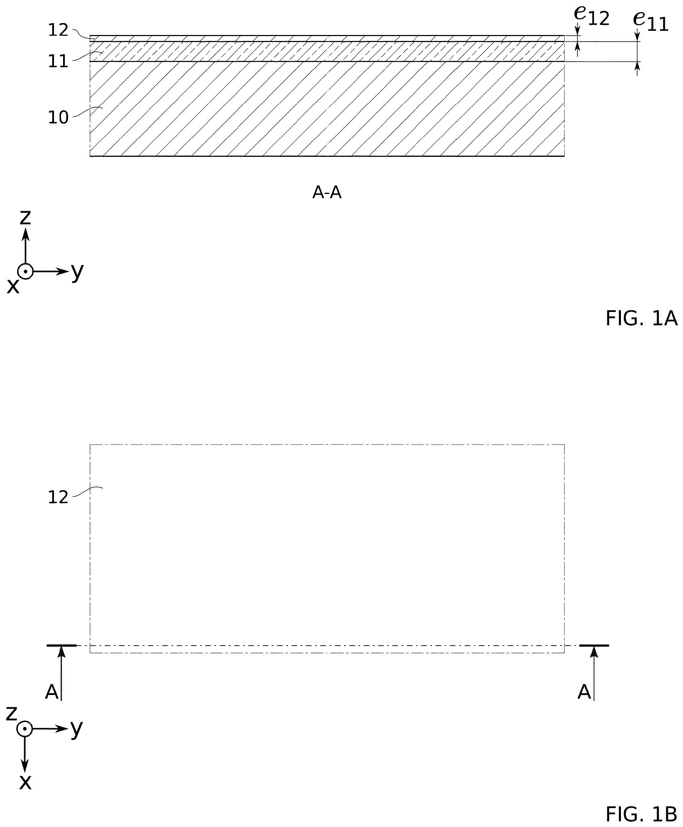

Les figures 1A, 2A, 3A, 4A, 5A, 6A, 7A, 8A, 9A, 10A, 11A, 12A, 13A, 14A, 15A, 16A, 17A illustrent schématiquement en coupe transverse des étapes de fabrication d'une grille arrière sous un dispositif semi-conducteur, selon un mode de réalisation. Les figures 1B, 2B, 3B, 4B, 5B, 6B, 7B, 8B, 9B, 10B, 11B, 12B, 13B, 14B, 15B, 16B, 17B illustrent schématiquement en vue de dessus les étapes de fabrication illustrées aux figures 1A, 2A, 3A, 4A, 5A, 6A, 7A, 8A, 9A, 10A, 11A, 12A, 13A, 14A, 15A, 16A, 17A correspondantes.

Comme illustré aux figures 1A, 1B, les premières étapes consistent à former de façon connue un empilement comprenant une couche de support 10, typiquement un substrat massif de silicium dit « bulk », une couche sacrificielle 11, par exemple une couche SiGe épitaxiée présentant une concentration atomique en germanium de l'ordre de 20% à 30%, et une couche superficielle semi-conductrice 12, par exemple une couche de silicium épitaxiée dite topSi dans la suite. La couche sacrificielle 11 présente typiquement une épaisseur e₁₁ de l'ordre de 5 nm à 50 nm. La couche topSi 12 présente typiquement une épaisseur e₁₂ de l'ordre de 5 nm à 20 nm.

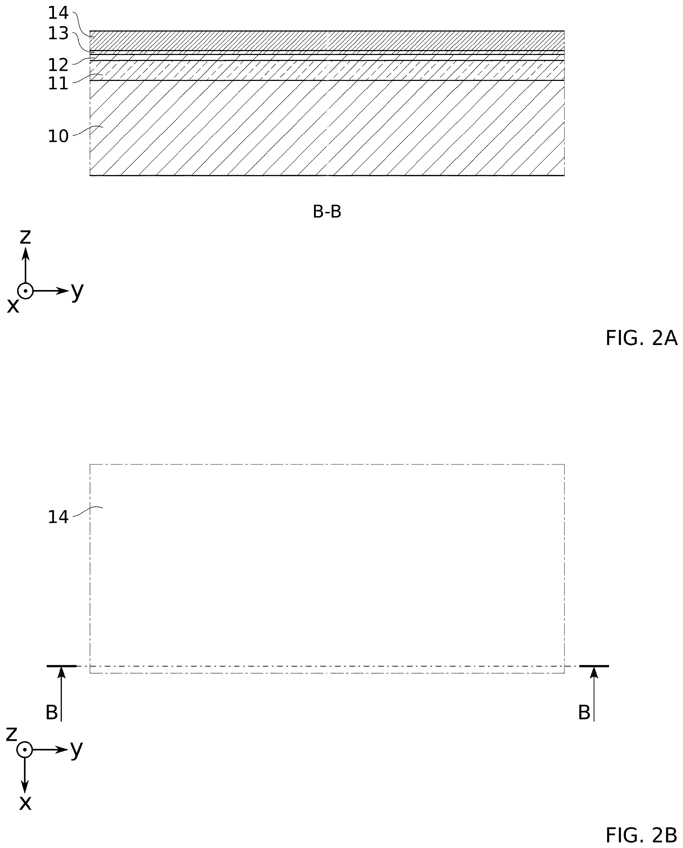

Comme illustré aux figures 2A, 2B, un masque dur comprenant typiquement une couche 13 à base de SiO2 et une couche 14 à base de SiN. La couche 13 peut être une couche de type PADOX (PAD OXide) selon un acronyme anglo-saxon bien connu de l'homme de métier. La couche 13 présente par exemple une épaisseur de l'ordre de 5 nm. La couche 14 présente par exemple une épaisseur de l'ordre de 30 nm. Ce masque dur est typiquement structuré et utilisé pour la gravure de motifs définis par lithographie.

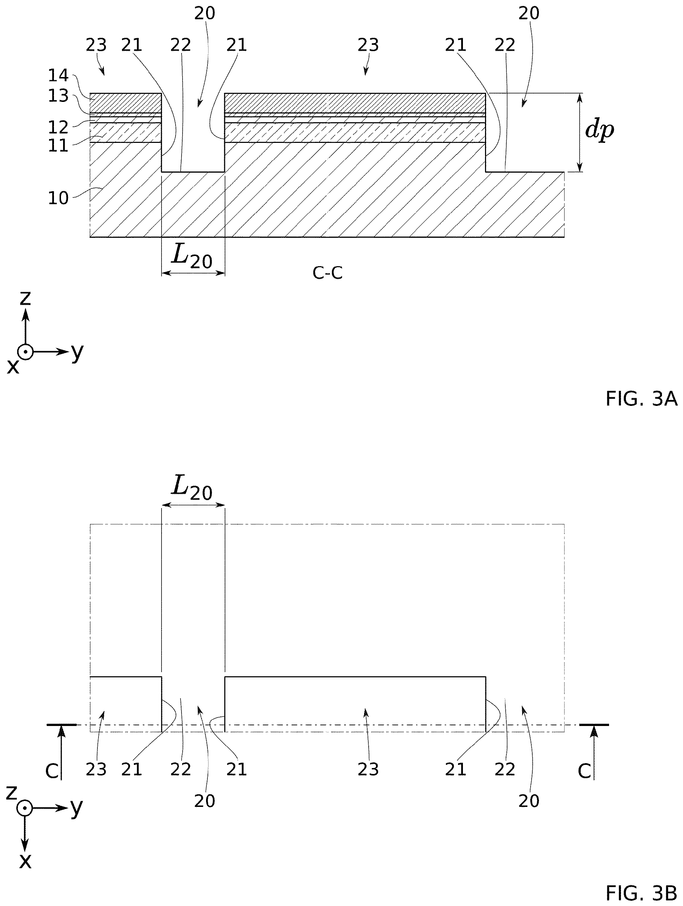

Comme illustré aux figures 3A, 3B, après définition par lithographie des motifs 20, 23 correspondant respectivement aux motifs de tranchée 20 et aux motifs de dispositifs 23, une gravure sèche anisotrope selon z est effectuée. La profondeur de gravure dp est choisie de façon à former les motifs de tranchée 20 au sein de la couche de support 10, à travers les couches 11, 12 de l'empilement. La profondeur de gravure dp est par exemple de l'ordre de 200 nm. Une gravure ionique réactive (RIE) ou une gravure plasma à base d'espèces fluorocarbonées peut être utilisée pour graver successivement les couches 12, 11 et 10 de l'empilement. Des motifs de tranchée 20 présentant des flancs 21 et un fond 22 sont ainsi formés. Ces motifs de tranchée 20 présentent une dimension en largeur selon y L₂₀.

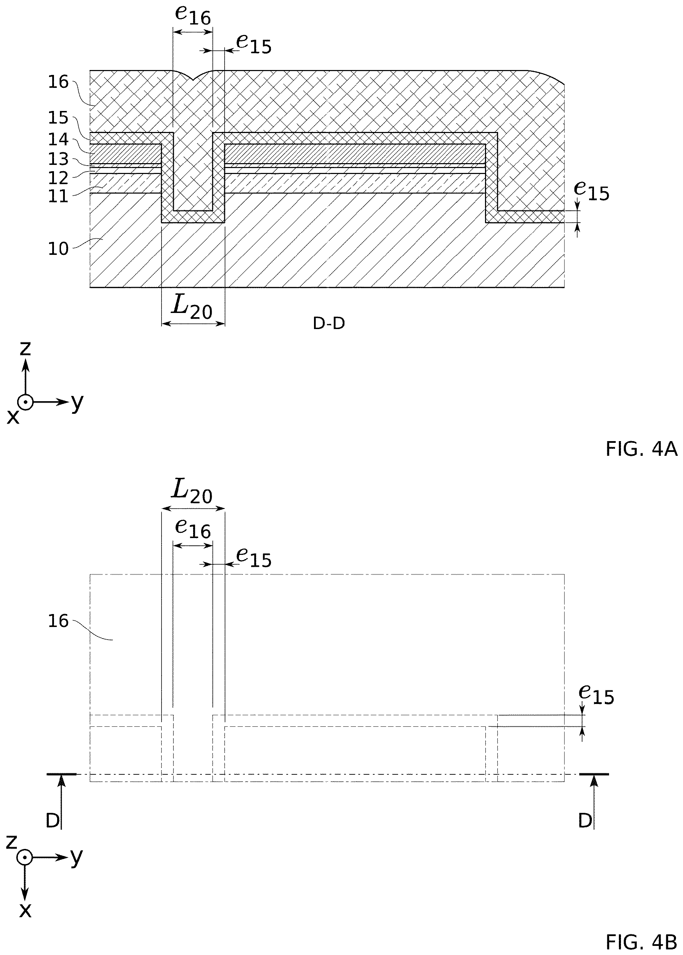

Comme illustré aux figures 4A, 4B, un dépôt conforme d'une couche de revêtement sacrificielle 15 est d'abord effectué, par exemple par dépôt chimique en phase vapeur CVD. La couche 15 présente typiquement une épaisseur e₁₅ de l'ordre de 10 nm à 20 nm. Selon une possibilité préférée, l'épaisseur e₁₅ est choisie telle que e₁₅ ≤ L₂₀/3. La couche de revêtement sacrificielle 15 est de préférence à base d'un matériau diélectrique, par exemple SiN ou SiC. Selon une possibilité illustrée aux figures 4A, 4B, après dépôt conforme de la couche de revêtement sacrificielle 15, un remplissage des motifs de tranchée 20 par un matériau isolant 16 est ensuite effectué. Le matériau isolant 16 est typiquement à base de SiO2. Le remplissage peut être effectué de façon usuelle par dépôt conforme de type plasma à haute densité HDP (High Density. Plasma) ou de type dépôt chimique en phase vapeur FCVD (Flowable Chemical Vapor Deposition), ou une combinaison de ceux-ci. Selon une possibilité, les dimensions latérales selon y e₁₅ et e₁₆ sont telles que e₁₅ ≤ e₁₆/3.

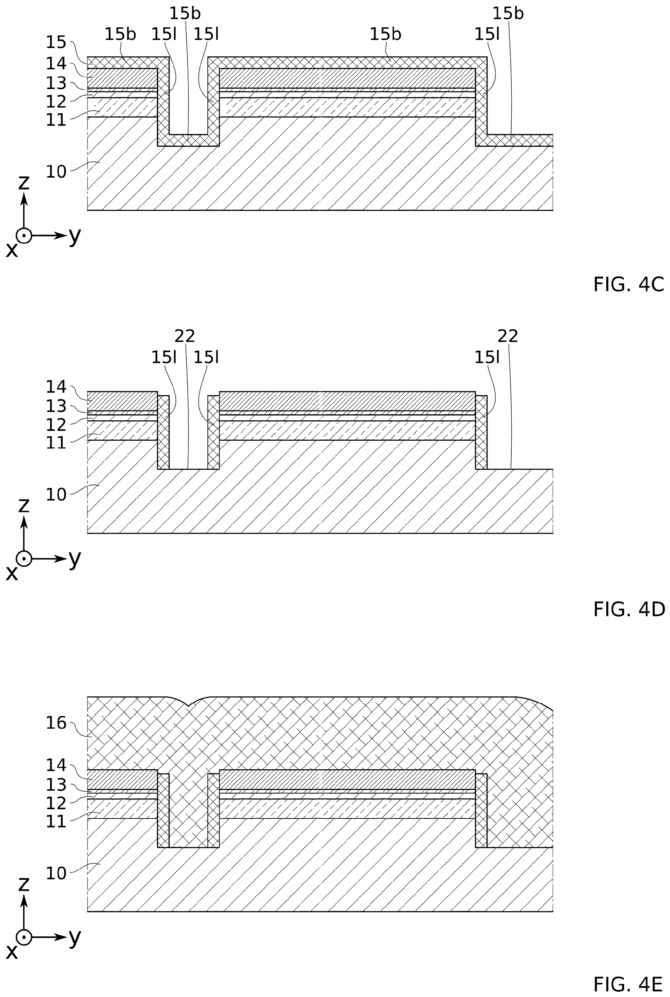

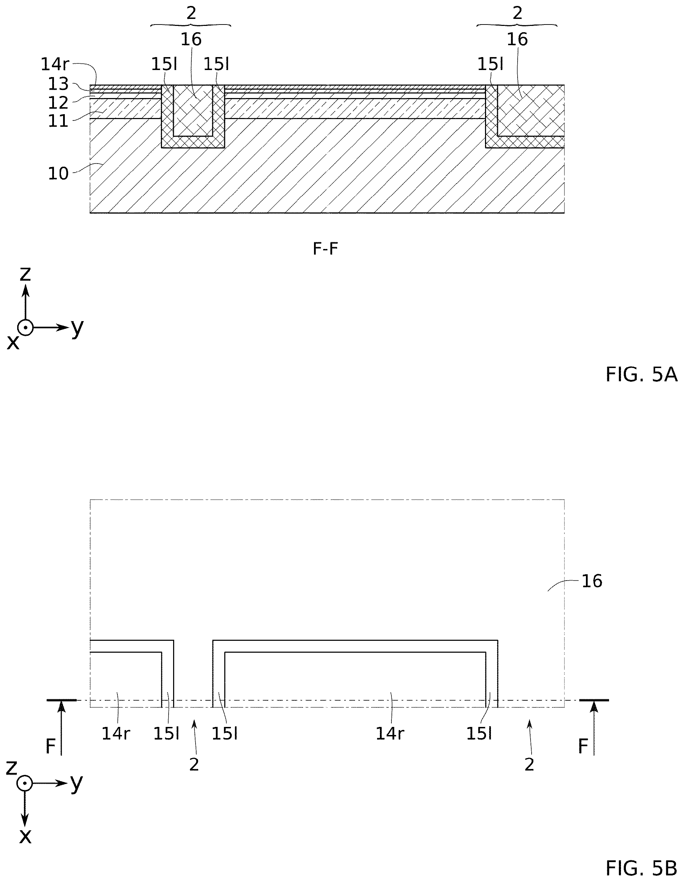

Selon une autre possibilité illustrée aux figures 4C, 4D, **4E****,** après dépôt conforme de la couche de revêtement sacrificielle 15 (figure 4C), les portions basales 15b de la couche 15 sont retirées par gravure anisotrope selon z. Le fond 22 des motifs de tranchée est ainsi exposé et tandis que les flancs 21 des motifs de tranchée sont couverts par les portions latérales 15l de la couche 15 (figure 4D). Le remplissage des motifs de tranchée 20 par le matériau isolant 16 est ensuite effectué comme précédemment (figure 4E). Comme illustré aux figures 5A, 5B, après remplissage, une étape de planarisation, typiquement par polissage mécano-chimique CMP, est effectuée. Cette étape de planarisation vise à retirer le matériau isolant 16 en excès pour former la face supérieure des tranchées d'isolation 2. Le polissage CMP est typiquement configuré pour s'arrêter dans la couche 14 de masque dur, en laissant un film résiduel 14r. Des tranchées d'isolation 2 de type STI (acronyme de « Shallow Trench Isolation » signifiant tranchée d'isolation superficielle ou peu profonde) comprenant des portions de couche de revêtement sacrificielle 15 au moins sur les flancs 21 ou sur les flancs 21 et sur le fond 22 (comme illustré à la figure 5A), et un noyau isolant 16, sont ainsi formées.

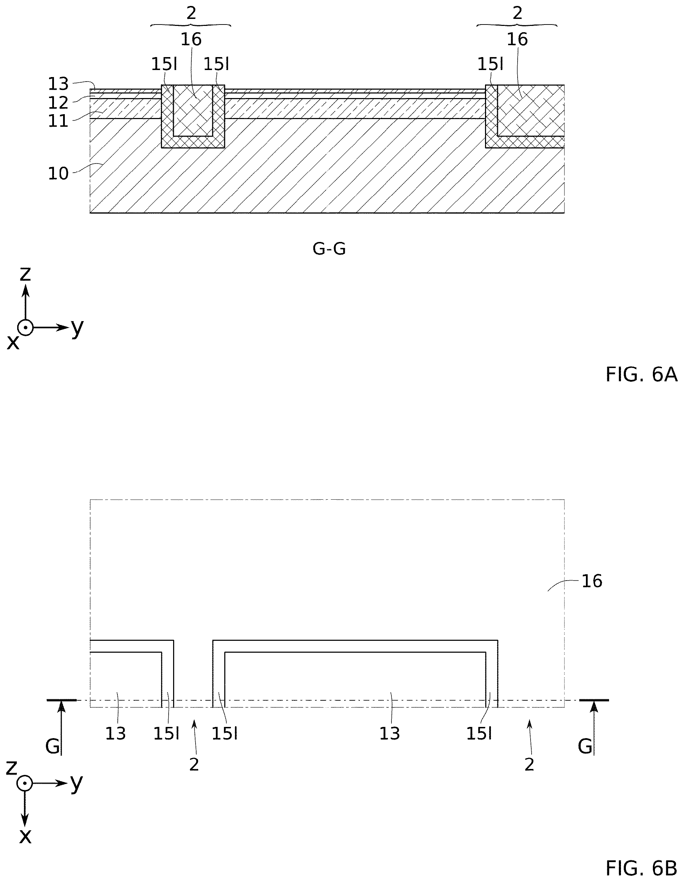

Comme illustré aux figures 6A, 6B, le film résiduel 14r de masque dur est ensuite retiré sélectivement vis-à-vis de la couche 13, du matériau isolant 16 et de préférence vis-à-vis des portions 15l exposées, par exemple en chimie humide de type H3PO4.

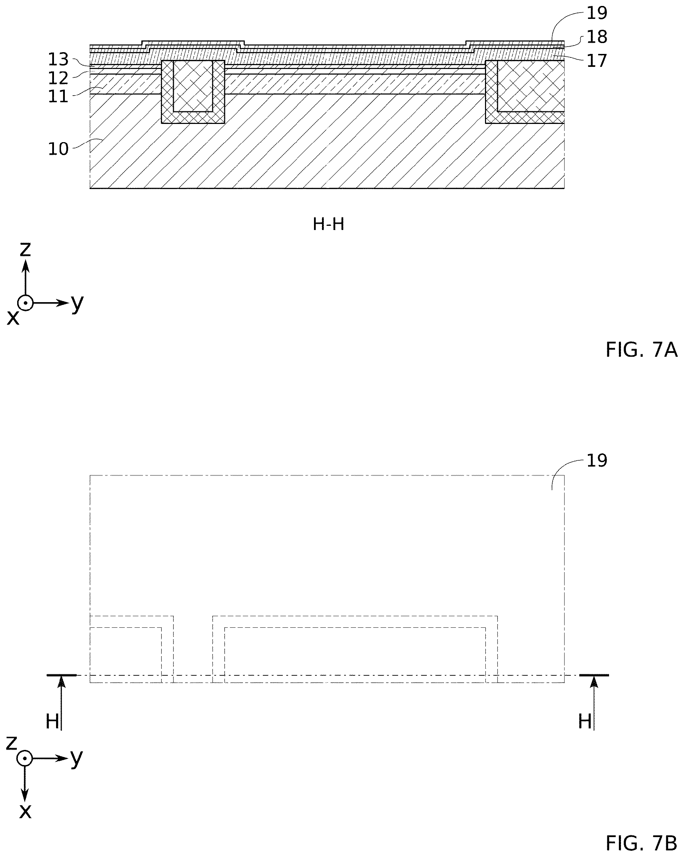

Comme illustré aux figures 7A, 7B, un empilement de grille standard est ensuite formé, comprenant par exemple, la couche d'oxyde 13 et/ou une couche dite « high k » à haute constante diélectrique, une couche 17 conductrice, par exemple en silicium polycristallin (polySi) et/ou en métal (TiN), surmontée par un masque dur comprenant typiquement une couche 18 à base de SiN et une couche 19 à base de SiO2.

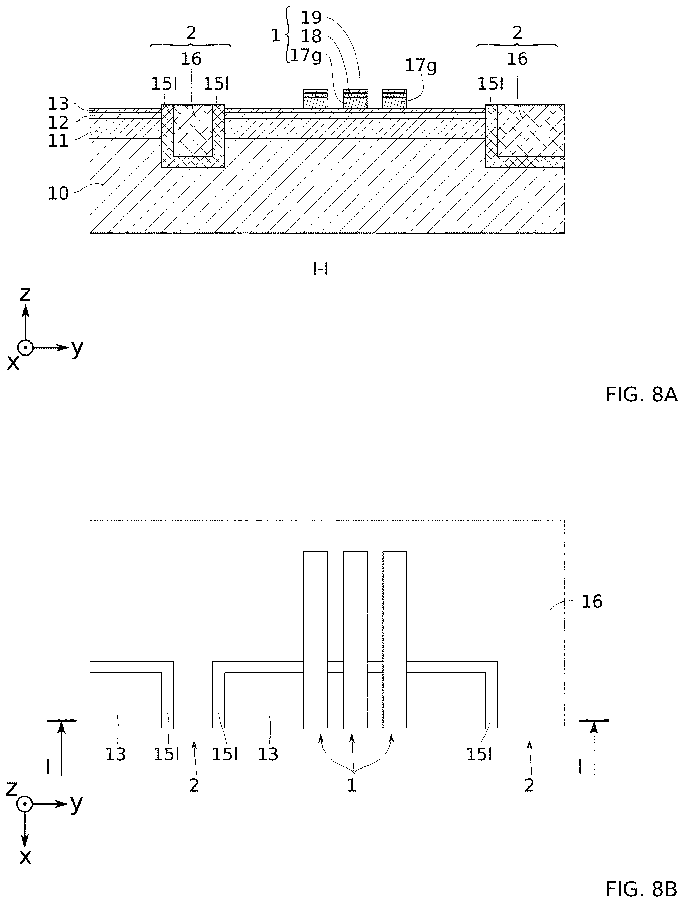

Comme illustré aux figures 8A, 8B, après définition par lithographie de motifs de grille 1, et structuration du masque dur, une gravure anisotrope selon z de l'empilement de grille est effectuée. Les motifs de grille 1 comprennent typiquement une grille 17g surmontée par le masque dur 18, 19. A ce stade, le film d'oxyde 13 protège la couche topSi 12 sous-jacente.

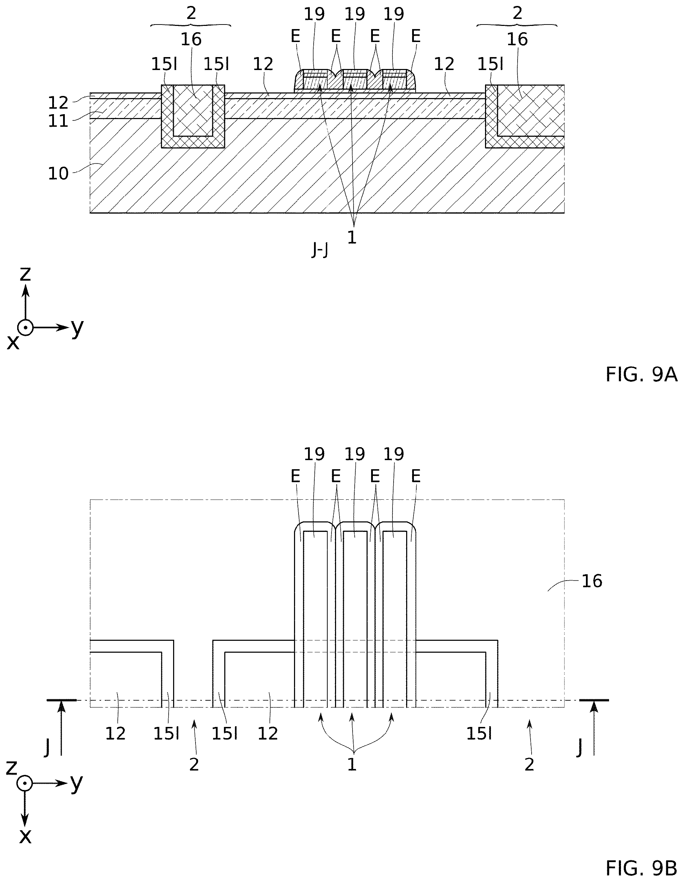

Comme illustré aux figures 9A, 9B, des espaceurs E sont ensuite formés sur les flancs des motifs de grille 1, par dépôt conforme puis gravure sèche d'une couche à base d'un diélectrique d'espaceur connu tel que SiO2, SiN, SiBCN, SiOCN, SiCO etc. Pour une application quantique, l'épaisseur de cette couche est de préférence définie pour combler l'espace entre les grilles 17g adjacentes. Pour une application en microélectronique classique, l'épaisseur de cette couche peut être choisie de manière arbitraire et laisser des espaces non comblés, notamment pour permettre une reprise ultérieure de contacts sur la couche topSi 12, entre les grilles 17g. La dimension selon y des espaceurs E est par exemple de l'ordre de 30 nm pour un espace inter-grille de 60 nm. La couche 13 est ensuite retirée autour des espaceurs **E,** de façon à exposer la couche topSi 12.

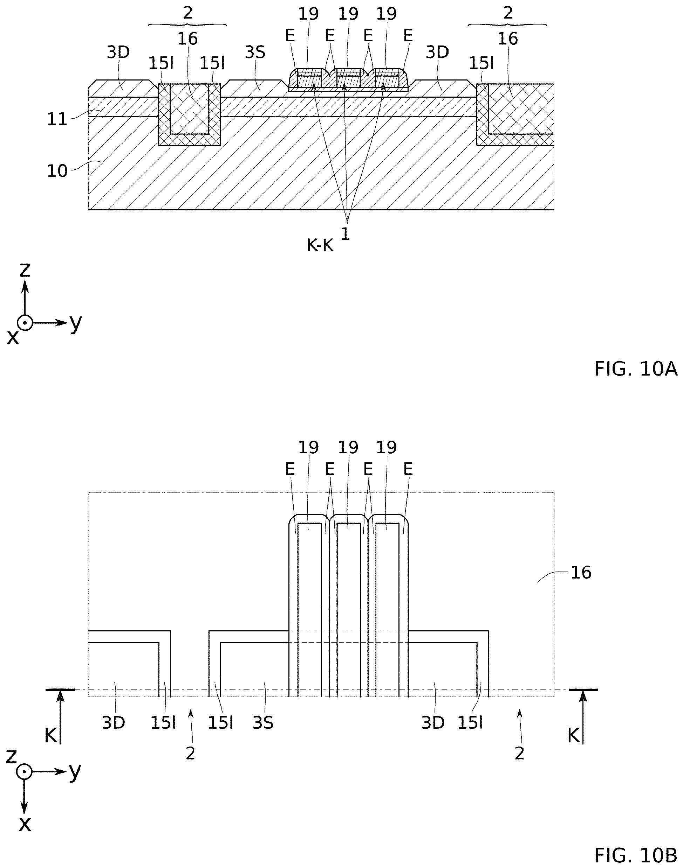

Comme illustré aux figures 10A, 10B, des régions source et drain 3S, 3D, ou des réservoirs pour des dispositifs quantiques, peuvent être formés par épitaxie sur les parties de la couche topSi 12 exposée. Ces régions 3S, 3D sont typiquement dopées in situ lors de l'épitaxie. Elles peuvent être à base de silicium dopé phosphore Si:P ou de silicium-germanium dopé bore SiGe:B par exemple.

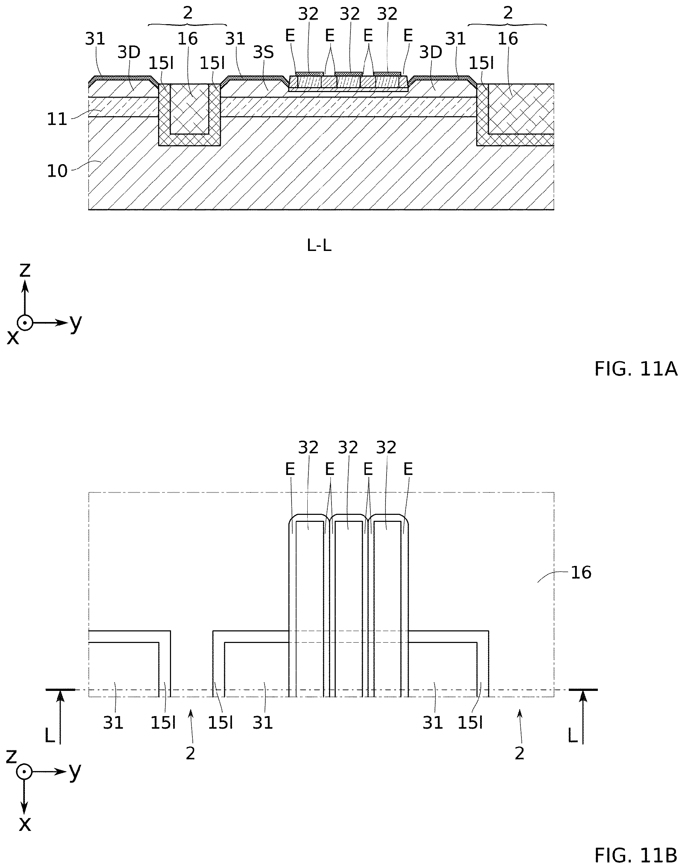

Comme illustré aux figures 11A, 11B, le masque dur couvrant le sommet des grilles 17g est retiré avant de mettre en œuvre un procédé de siliciuration configuré pour former des portions siliciurées 31, 32, par exemple à base de NiPtSi(Ge), au sommet des régions 3S, 3D et des grilles 17g.

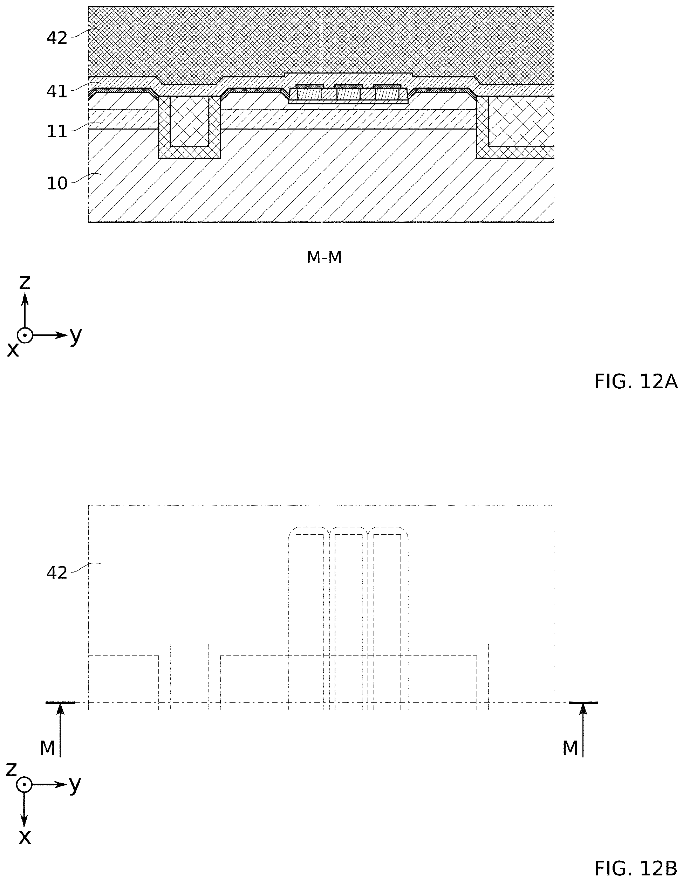

Comme illustré aux figures 12A, 12B, un dépôt conforme d'une couche 41 d'arrêt de gravure de contact CESL (Contact Etch Stop Layer), par exemple en SiN d'épaisseur e₄₁ de l'ordre de 30 nm, est d'abord effectué. Ce dépôt peut se faire selon un procédé de dépôt chimique en phase vapeur assisté par plasma PECVD. Un dépôt de matériau 42 diélectrique pré-métallique (PMD), par exemple à base de SiO2, est ensuite effectué. Ce dépôt peut se faire selon un procédé connu de dépôt HDP, HARP (acronyme de « high aspect ratio process » soit procédé pour facteurs de forme élevés), FCVD ou à partir de précurseurs de type TEOS (orthosilicate de tétraéthyle). La couche 42 est ensuite planarisée par CMP.

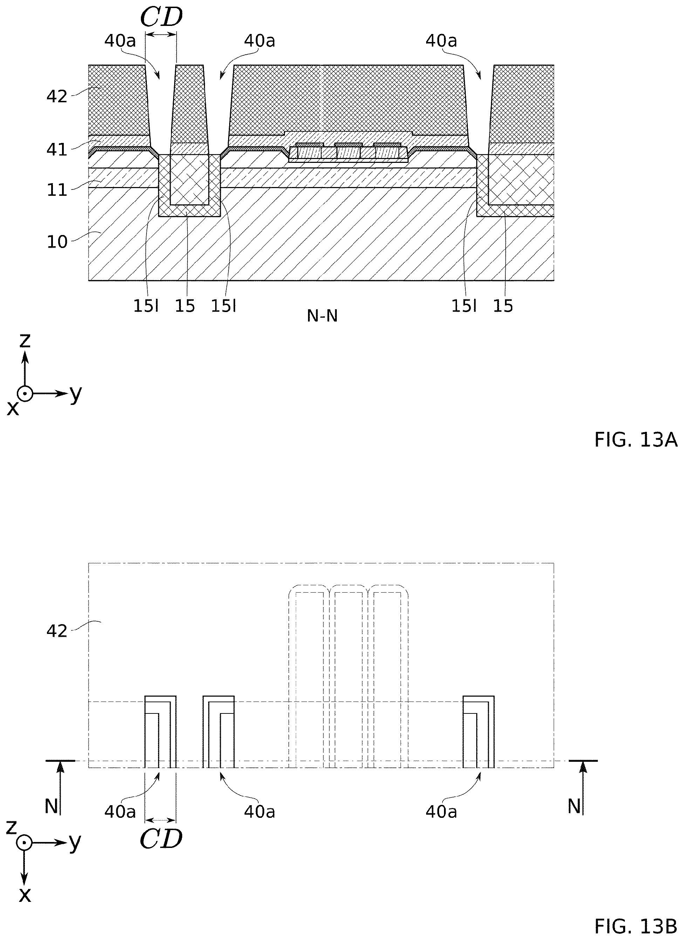

Comme illustré aux figures 13A, 13B, des ouvertures 40a sont ensuite pratiquées dans la couche 42 et la couche 41, par gravures sèches successives, à l'aplomb des portions 15l de la couche de revêtement sacrificielle des tranchées d'isolation STI. Avantageusement, la dimension latérale CD selon y des ouvertures 40a est supérieure ou égale à l'épaisseur e₁₅ de la couche de revêtement sacrificielle 15, 15l.

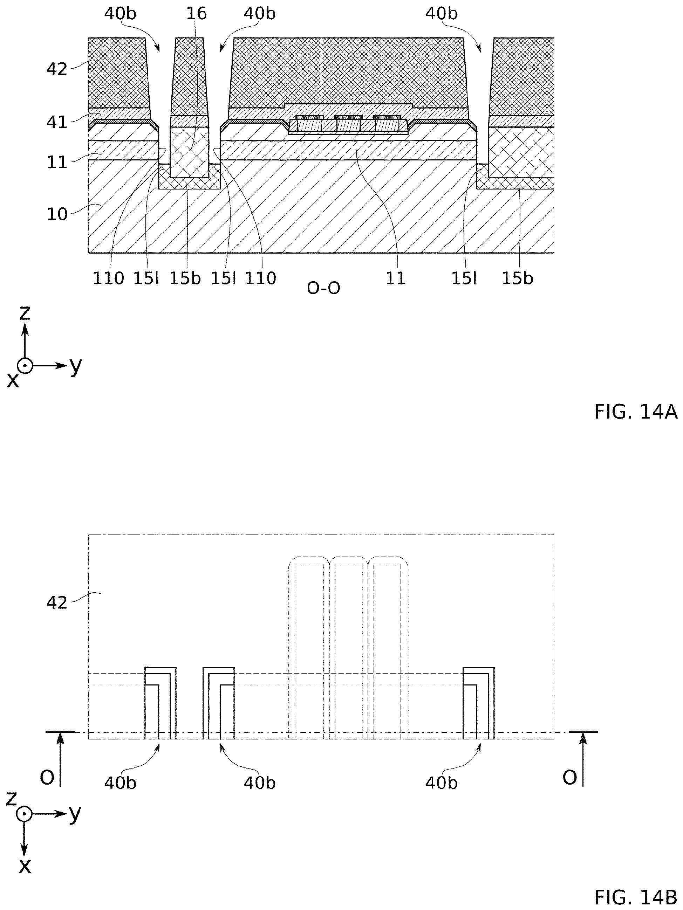

Comme illustré aux figures 14A, 14B, une gravure sélective partielle de la couche de revêtement sacrificielle 15, 15l est ensuite effectuée au travers des ouvertures 40a de manière à former des ouvertures 40b débouchant sur les flancs 110 de la couche sacrificielle 11. La gravure partielle est de préférence configurée pour découvrir totalement les flancs 110 de la couche sacrificielle 11. Dans cet exemple, la gravure partielle est arrêtée de façon à conserver au moins en partie les portions basales 15b de la couche de revêtement sacrificielle 15, de façon à préserver la tenue mécanique du noyau 16 dans les tranchées d'isolation. Des parties inférieures des portions latérales 15l de la couche de revêtement sacrificielle 15, situées sous les flancs 110, peuvent également être conservées pour améliorer la tenue mécanique. Dans cet exemple, la couche de revêtement sacrificielle 15 est à base d'un matériau diélectrique, par exemple SiN ou SiC, pour assurer la fonction d'isolation électrique avec le noyau 16. La gravure sélective partielle se fait de préférence par voie sèche. Dans le cas de SiN, une gravure humide à base d'une solution d'acide phosphorique H3PO4 peut également être mise en oeuvre.

Selon une autre possibilité non illustrée, dans le cas des tranchées d'isolation alternatives obtenues selon la variante de procédé illustrée aux figures 4D, 4E, la gravure sélective de la couche de revêtement sacrificielle 15 peut être totale. Ces tranchées d'isolation alternatives sont en effet dépourvues des portions basales de la couche de revêtement sacrificielle 15, et le noyau 16 isolant repose directement sur le fond 22 des motifs de tranchée. L'arrêt de la gravure est dans ce cas facilité. Par ailleurs, il est possible d'utiliser un matériau conducteur, par exemple du polySi, pour la couche de revêtement sacrificielle 15 dans le cas de ces tranchées d'isolation alternatives. Le noyau 16 seul est ici en mesure d'assurer la fonction d'isolation électrique des tranchées d'isolation alternatives. La gravure sélective totale peut se faire par voie humide, par exemple à partir d'une solution d'hydroxyde de tétraméthylammonium TMAH pour le polySi.

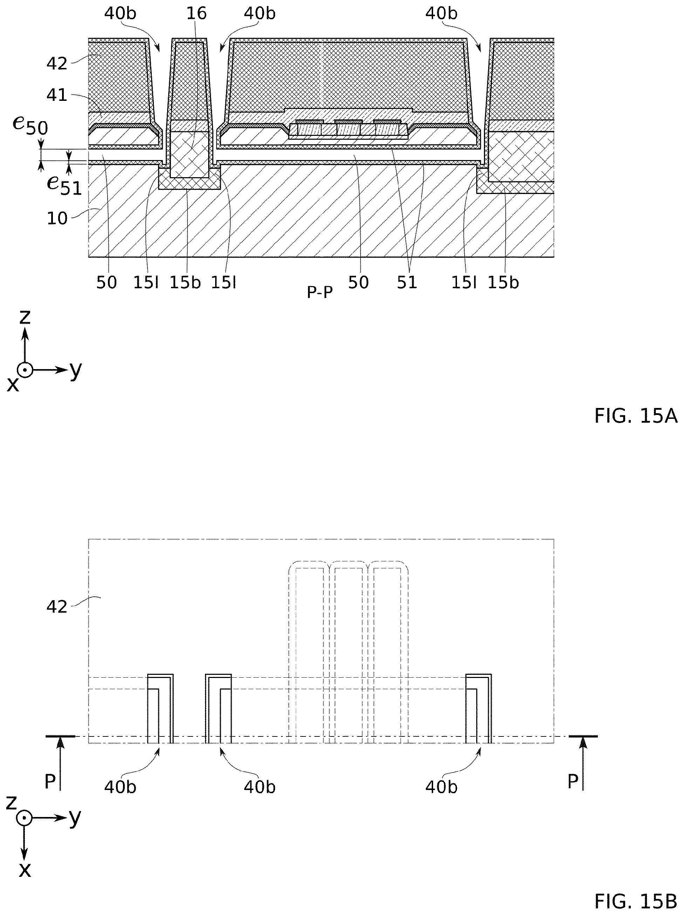

Comme illustré aux figures 15A, 15B, une gravure sélective par voie humide de la couche sacrificielle 11 vis-à-vis des couches de support et de topSi 10, 12 et vis-à-vis des noyaux 16, est effectuée au travers des ouvertures 40b. Dans le cas d'une couche sacrificielle 11 en SiGe et de couches 10, 12 en silicium, une gravure sélective peut être obtenue à partir d'une solution d'acide chlorhydrique HCl ou d'un mélange HF:H2O2:CH3COOH.

Après retrait de la couche sacrificielle 11, les parois de la cavité 50 sont revêtues par une couche 51 en un matériau diélectrique, par exemple SiN ou SiO2, de façon à isoler électriquement la future grille arrière vis-à-vis de la couche de support 10 et du topSi 12. Cette couche 51 présente de préférence une épaisseur e₅₁ comprise entre 2 nm et 10 nm. Elle peut être formée par un procédé de dépôt conforme de type dépôt chimique en phase vapeur assisté par plasma PECVD ou dépôt chimique en phase vapeur à basse pression LPCVD ou PEALD (acronyme de « Plasma Enhanced Atomic Layer Deposition » soit dépôt de couche atomique assisté par plasma). La cavité 50 présente alors une hauteur e₅. Les règles de dimensionnement sont de préférence telles que e₅₁ < e₁₅/3 et e₅₁ < e₅/3, et de préférence telles que e₅₁ < e₁₅/4 et e₅₁ < e₅/4. Cela permet de préserver des sections d'ouverture suffisamment grandes, entre les ouvertures 40b et la cavité 50, pour permettre le remplissage ultérieur par un matériau conducteur.

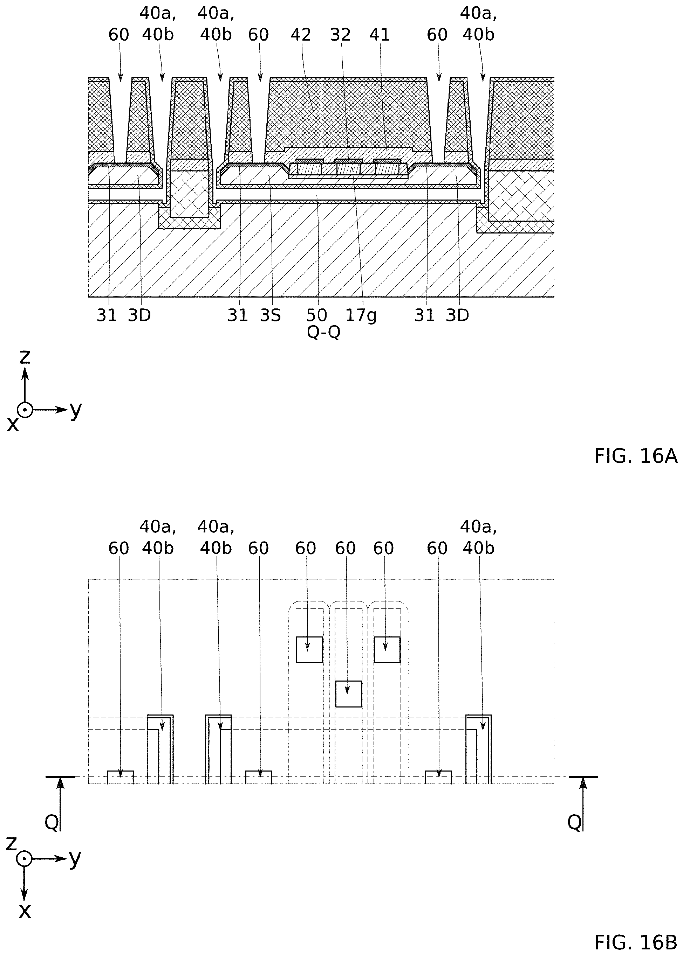

Comme illustré aux figures 16A, 16B, des ouvertures de contact 60 sont ensuite réalisées dans les couches 42, 41, à l'aplomb des portions siliciurées 31 des régions 3S, 3D, et à l'aplomb des portions siliciurées 32 des grilles 17g. Ces ouvertures de contact 60 peuvent être réalisées de la même manière que les ouvertures 40a. En particulier, lors de la définition des contacts par lithographie, les ouvertures 40a sont typiquement bouchées par la ou les couches de lithographie (non illustré). Cela permet de ne pas endommager les ouvertures 40a lors de la formation des ouvertures de contact 60.

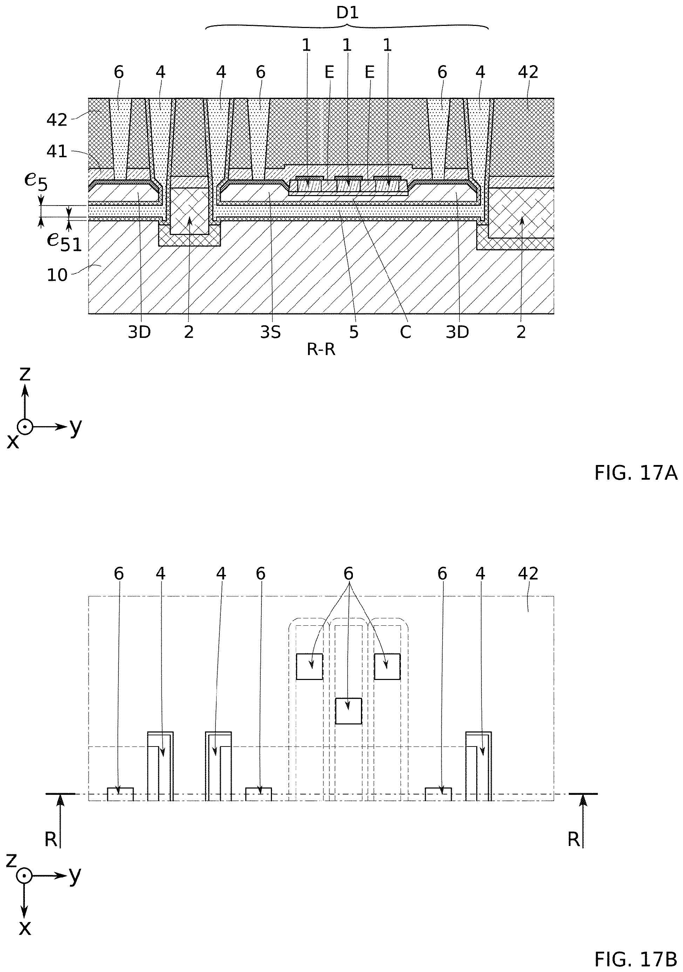

Comme illustré aux figures 17A, 17B, un ou plusieurs dépôts de matériaux métalliques sont effectués pour remplir les cavités 50, les ouvertures 40a, 40b et les ouvertures de contact 60 simultanément. Une combinaison de métaux tels que Ti/TiN/W est par exemple utilisée. De façon préférée, un procédé CVD est utilisé pour assurer la conformité du dépôt métallique sur les parois de la cavité 50. Un dispositif D1 comprenant des motifs de grille 1 sur une couche semi-conductrice ou un canal C, des réservoirs ou des régions source et drain 3S, 3D, des contacts de grille arrière 4 et une grille arrière 5 sous les motifs de grille 1 et le canal C, et des contacts 6 est ainsi obtenu. Ce dispositif D1 est isolé électriquement vis-à-vis de dispositifs adjacents par les tranchées d'isolation 2. Les dispositifs adjacents peuvent être similaires ou identiques au dispositif D1. Des grilles arrière 5 sont ainsi formées simultanément pour plusieurs dispositifs adjacents isolés entre eux grâce au procédé selon l'invention.

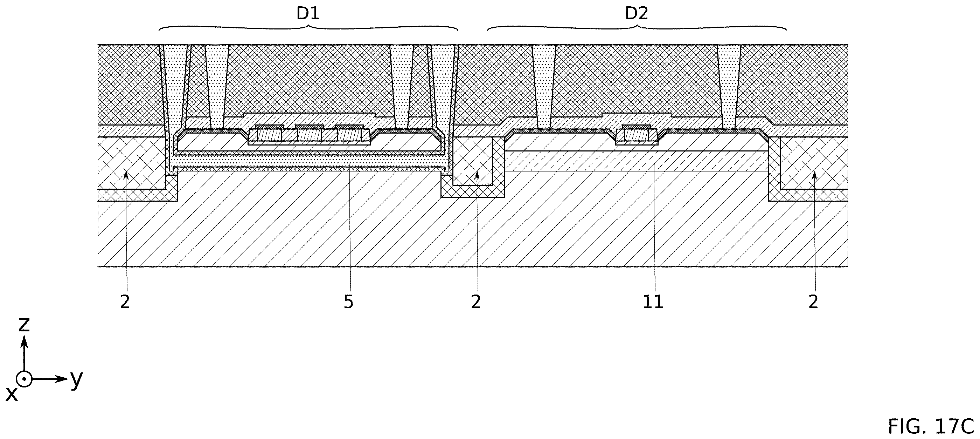

Selon une possibilité illustrée à la figure 17C, le procédé selon l'invention permet également de former une grille arrière 5 sur un seul dispositif D1, sans former de grille arrière sur le dispositif D2 adjacent au dispositif D1. Cette possibilité de mise en oeuvre se fait sans modifier le dimensionnement des tranchées d'isolation 2, ce qui préserve une bonne densité d'intégration ou de co-intégration des dispositifs D1, D2. Typiquement, il suffit de former des ouvertures 40a, 40b uniquement à l'aplomb des portions latérales de la couche de revêtement sacrificielle situées à proximité immédiate du dispositif requérant une grille arrière. Ainsi, seule la couche sacrificielle située sous le dispositif D1 est retirée pour former la grille arrière 5. Le dispositif D2 adjacent, qui peut être de nature différente (par exemple un simple transistor MOSFET) ou avoir une fonction logique différente, n'est avantageusement pas affecté par la formation de la grille arrière 5 sous le dispositif D1. Au vu de la description qui précède, il apparaît clairement que le procédé proposé offre une solution particulièrement efficace et versatile pour former une grille arrière sous un dispositif semi-conducteur, en préservant ou en améliorant la densité d'intégration de ce dispositif semi-conducteur.

L'invention est définie par les revendications.

## Revendications

1. Procédé de réalisation d'une grille arrière (5) sous un dispositif semi-conducteur (D1), ledit dispositif semi-conducteur (D1) étant formé sur une couche semi-conductrice (12) d'un empilement comprenant successivement une couche de support (10), une couche sacrificielle (11) et la couche semi-conductrice (12), ledit procédé comprenant :
• une formation de tranchées d'isolation (2) autour du dispositif semi-conducteur (D1), lesdites tranchées d'isolation (2) traversant la couche semi-conductrice (12) superficielle et la couche sacrificielle (11), et s'étendant jusqu'à la couche de support (10),
• une gravure partielle des tranchées d'isolation (2) de sorte à former une ouverture (40b) débouchant sur la couche sacrificielle (11),
• un retrait de la couche sacrificielle (11) sélectivement à la couche semi-conductrice (12), à la couche de support (10) et aux tranchées d'isolation (2), de sorte à former une cavité (50) sous le dispositif semi-conducteur (D1),
• un remplissage de la cavité (50) par un matériau électriquement conducteur de sorte à former la grille arrière (5) sous le dispositif semi-conducteur (D1),
la formation des tranchées d'isolation (2) comprenant :
• une première gravure configurée pour former au moins un motif de tranchée (20) présentant un fond (22) et des flancs (21),
• une formation d'une couche de revêtement sacrificielle (15) au moins sur les flancs (21) de l'au moins un motif de tranchée (20), en contact avec la couche sacrificielle (11) de l'empilement,
ledit procédé étant **caractérisé en ce que** la formation des tranchées d'isolation (2) comprend en outre, après formation de la couche de revêtement sacrificielle (15) :
• un remplissage de l'au moins un motif de tranchée (20) par un matériau isolant (16), configuré de sorte que ledit matériau isolant (16) s'étende au moins jusqu'au sein de la couche sacrificielle (11) de l'empilement, et de préférence jusqu'au sein de la couche de support (10) de l'empilement,
et **en ce que** la gravure partielle des tranchées d'isolation (2) comprend :
• un retrait de la couche de revêtement sacrificielle (15) sélectivement au matériau isolant (16).

2. Procédé selon la revendication précédente dans lequel le dispositif semi-conducteur (D1) est un dispositif quantique et dans lequel le matériau électriquement conducteur est métallique.

3. Procédé selon l'une quelconque des revendications précédentes dans lequel le dispositif semi-conducteur (D1) est adjacent à un deuxième dispositif semi-conducteur (D2) séparé du dispositif semi-conducteur (D1) par une tranchée d'isolation (2) présentant un premier flanc du côté du dispositif semi-conducteur (D1) et un deuxième flanc du côté du deuxième dispositif semi-conducteur (D2), ladite tranchée d'isolation (2) comprenant une première portion de couche de revêtement sacrificielle (15l) sur le premier flanc et une deuxième portion de couche de revêtement sacrificielle (15l) sur le deuxième flanc,
dans lequel la gravure partielle de ladite tranchée d'isolation (2) comprend un retrait simultané des première et deuxième portions (15l) de couche de revêtement sacrificielle, de sorte à former une première grille arrière (5) sous le dispositif semi-conducteur (D1) et une deuxième grille arrière (5) sous le deuxième dispositif semi-conducteur (D2).

4. Procédé selon l'une quelconque des revendications 1 à 2 dans lequel le dispositif semi-conducteur (D1) est adjacent à un deuxième dispositif semi-conducteur (D2) séparé du dispositif semi-conducteur (D1) par une tranchée d'isolation (2) présentant un premier flanc du côté du dispositif semi-conducteur (D1) et un deuxième flanc du côté du deuxième dispositif semi-conducteur (D2), ladite tranchée d'isolation (2) comprenant une première portion de couche de revêtement sacrificielle (15l) sur le premier flanc et une deuxième portion de couche de revêtement sacrificielle (15l) sur le deuxième flanc,
dans lequel la gravure partielle de ladite tranchée d'isolation (2) comprend un retrait de la première portion de couche de revêtement sacrificielle (15l) uniquement, sans retrait de la deuxième portion de couche de revêtement sacrificielle,
de sorte à former la grille arrière (5) uniquement sous le dispositif semi-conducteur (D1), en conservant une portion de couche sacrificielle (11) sous le deuxième dispositif semi-conducteur (D2).

5. Procédé selon l'une quelconque des revendications précédentes dans lequel la formation de la couche de revêtement sacrificielle (15) se fait par dépôt conforme sur les flancs (21) et le fond (22) de l'au moins un motif de tranchée (20).

6. Procédé selon la revendication précédente dans lequel le retrait de la couche de revêtement sacrificielle (15) est uniquement partiel et configuré pour conserver une portion (15b) de la couche de revêtement sacrificielle située sur le fond (22) de l'au moins un motif de tranchée (20).

7. Procédé selon l'une quelconque des revendications 1 à 4 dans lequel la formation de la couche de revêtement sacrificielle (15) comprend un dépôt conforme sur les flancs (21) et le fond (22) de l'au moins un motif de tranchée (20), suivi d'une gravure anisotrope configurée pour retirer une portion (15b) de la couche de revêtement sacrificielle située sur le fond (22) de l'au moins un motif de tranchée (20), de sorte que la couche de revêtement sacrificielle (15, 15l) couvre uniquement les flancs (21) de l'au moins un motif de tranchée (20), avant remplissage de l'au moins un motif de tranchée (20) par le matériau isolant (16).

8. Procédé selon la revendication précédente dans lequel le retrait de la couche de revêtement sacrificielle (15, 15l) est total.

9. Procédé selon l'une quelconque des revendications précédentes dans lequel la couche de revêtement sacrificielle (15) est choisie à base d'un premier matériau diélectrique, par exemple SiN ou SiC.

10. Procédé selon l'une quelconque des revendications précédentes dans lequel la formation de la couche de revêtement sacrificielle (15) est configurée de sorte que la couche de revêtement sacrificielle (15) présente une épaisseur e15 selon une direction (y) transverse aux flancs (21) de l'au moins un motif de tranchée (20), et le remplissage de l'au moins un motif de tranchée (20) par le matériau isolant (16) est configuré de sorte que le matériau isolant présente une épaisseur e16 selon ladite direction (y) transverse, telles que e15 < e16/3.

11. Procédé selon l'une quelconque des revendications précédentes comprenant en outre, après retrait de la couche sacrificielle (15) et avant remplissage de la cavité (20) par un matériau électriquement conducteur, un dépôt conforme d'une couche (51) en un deuxième matériau diélectrique sur des parois exposées de la cavité (50), par exemple par dépôt chimique en phase vapeur (CVD).

12. Procédé selon la revendication précédente dans lequel la couche (51) en un deuxième matériau diélectrique présente une épaisseur e51, la couche de revêtement sacrificielle (15) présente une épaisseur e15, le matériau électriquement conducteur présente une épaisseur e5, telles que e51 < e15/3 et e51 < e5/3, et de préférence telles que e51 < e15/4 et e51 < e5/4.

13. Procédé selon l'une quelconque des revendications précédentes dans lequel le matériau isolant (16) des tranchés d'isolation (2) est choisi à base de SiO2.

14. Procédé selon l'une quelconque des revendications précédentes dans lequel la couche sacrificielle (11) est formée sur la couche de support (10) par épitaxie, ladite couche sacrificielle (11) étant par exemple à base de SiGe.

## Patentansprüche

1. Verfahren zur Herstellung eines Rückgitters (5) unter einer Halbleiteranordnung (D1), wobei die Halbleiteranordnung (D1) auf einer Halbleiterschicht (12) einer Stapelung gebildet ist, die nacheinander eine Trägerschicht (10), eine Opferschicht (11) und eine Halbleiterschicht (12) umfasst, wobei
das Verfahren Folgendes umfasst:
• Bilden von Isoliergräben (2) um die Halbleiteranordnung (D1), wobei die Isoliergräben (2) die oberflächliche Halbleiterschicht (12) und die Opferschicht (11) durchqueren und sich bis zu der Trägerschicht (10) erstrecken,
• teilweises Ätzen der Isoliergräben (2) derart, dass eine Öffnung (40b) gebildet wird, die auf der Opferschicht (11) mündet,
• selektives Entfernen der Opferschicht (11) an der Halbleiterschicht (12), an der Trägerschicht (10) und an den Isoliergräben (2) derart, dass unter der Halbleiteranordnung (D1) ein Hohlraum (50) gebildet wird,
• Füllen des Hohlraums (50) mit einem elektrisch leitfähigen Material derart, dass das Rückgitter (5) unter der Halbleiteranordnung (D1) gebildet wird,
wobei das Bilden der Isoliergräben (2) Folgendes umfasst:
• erstes Ätzen, die dazu konfiguriert ist, mindestens eine Grabenstruktur (20) zu bilden, die einen Grund (22) und Flanken (21) aufweist,
• Bilden einer Opferbeschichtungsschicht (15) mindestens auf den Flanken (21) der mindestens einen Grabenstruktur (20) in Kontakt mit der Opferschicht (11) der Stapelung,
Verfahren **dadurch gekennzeichnet, dass** das Bilden der Isoliergräben (2) außerdem nach dem Bilden der Opferbeschichtungsschicht (15) Folgendes umfasst:
• Füllen der mindestens einen Grabenstruktur (20) durch ein Isoliermaterial (16), das dazu konfiguriert ist, dass sich das Isoliermaterial (16) mindestens bis in die Opferschicht (11) der Stapelung erstreckt und bevorzugt bis in die Trägerschicht (10) der Stapelung, und dass das teilweise Ätzen der Isoliergräben (2) Folgendes umfasst:
• selektives Entfernen der Opferbeschichtungsschicht (15) an dem Isoliermaterial (16).

2. Verfahren nach dem vorstehenden Anspruch, wobei die Halbleiteranordnung (D1) eine Quantenvorrichtung ist, und wobei das elektrisch leitfähige Material metallisch ist.

3. Verfahren nach einem der vorstehenden Ansprüche, wobei die Halbleiteranordnung (D1) an eine zweite Halbleiteranordnung (D2) angrenzt, die von der Halbleiteranordnung (D1) durch einen Isoliergraben (2) getrennt ist, der eine erste Flanke auf der Seite der Halbleiteranordnung (D1) und eine zweite Flanke auf der Seite der zweiten Halbleiteranordnung (D2) aufweist, wobei der Isoliergraben (2) einen ersten Abschnitt Opferbeschichtungsschicht (15l) auf der ersten Flanke und einen zweiten Abschnitt Opferbeschichtungsschicht (15l) auf der zweiten Flanke umfasst,
wobei das teilweise Ätzen des Isoliergrabens (2) ein gleichzeitiges Entfernen des ersten und des zweiten Abschnitts Operbeschichtungsschicht (15l) derart umfasst, dass ein erstes Rückgitter (5) unter der Halbleiteranordnung (D1) und ein zweites Rückgitter (5) unter der zweiten Halbleiteranordnung (D2) gebildet wird.

4. Verfahren nach einem der Ansprüche 1 bis 2, wobei die Halbleiteranordnung (D1) an eine zweite Halbleiteranordnung (D2) angrenzt, die von der Halbleiteranordnung (D1) durch einen Isoliergraben (2) getrennt ist, der eine erste Flanke auf der Seite der Halbleiteranordnung (D1) und eine zweite Flanke auf der Seite der zweiten Halbleiteranordnung (D2) aufweist, wobei der Isoliergraben (2) einen ersten Abschnitt Opferbeschichtungsschicht (15l) auf der ersten Flanke und einen zweiten Abschnitt Opferbeschichtungsschicht (15l) auf der zweiten Flanke umfasst, wobei das teilweise Ätzen des Isoliergrabens (2) ein Entfernen lediglich des ersten Abschnitts Opferbeschichtungsschicht (15l) ohne Entfernen des zweiten Abschnitts Opferbeschichtungsschicht derart umfasst, dass das Rückgitter (5) lediglich unter der Halbleiteranordnung (D1) gebildet wird, wobei ein Abschnitt Opferschicht (11) unter der zweiten Halbleiteranordnung (D2) bewahrt wird.

5. Verfahren nach einem der vorstehenden Ansprüche, wobei das Bilden der Opferbeschichtungsschicht (15) durch konformes Abscheiden auf den Flanken (21) und dem Grund (22) der mindestens einen Grabenstruktur (20) erfolgt.

6. Verfahren nach dem vorstehenden Anspruch, wobei das Entfernen der Opferbeschichtungsschicht (15) lediglich teilweise ist und dazu konfiguriert ist, einen Abschnitt (15b) der Opferbeschichtungsschicht zu bewahren, der sich auf dem Grund (22) der mindestens einen Grabenstruktur (20) befindet.

7. Verfahren nach einem der Ansprüche 1 bis 4, wobei das Bilden der Opferbeschichtungsschicht (15) ein konformes Abscheiden auf den Flanken (21) und dem Grund (22) der mindestens einen Grabenstruktur (20) gefolgt von einem anisotropen Ätzen umfasst, das dazu konfiguriert ist, einen Abschnitt (15b) der Opferbeschichtungsschicht, der sich auf dem Grund (22) der mindestens einen Grabenstruktur (20) befindet, derart zu entfernen, dass die Opferbeschichtungsschicht (15, 15l) lediglich die Flanken (21) der mindestens einen Grabenstruktur (20) vor dem Füllen der mindestens einen Grabenstruktur (20) mit dem Isoliermaterial (16) bedeckt.

8. Verfahren nach dem vorstehenden Anspruch, wobei das Entfernen der Opferbeschichtungsschicht (15, 15l) vollständig ist.

9. Verfahren nach einem der vorstehenden Ansprüche, wobei die Opferbeschichtungsschicht (15) auf Basis eines ersten dielektrischen Materials, beispielsweise SiN oder SiC, ausgewählt wird.

10. Verfahren nach einem der vorstehenden Ansprüche, wobei das Bilden der Opferbeschichtungsschicht (15) derart konfiguriert ist, dass die Opferbeschichtungsschicht (15) eine Dicke e15 entlang einer Richtung (y) quer zu den Flanken (21) der mindestens einen Grabenstruktur (20) aufweist, und das Füllen der mindestens einen Grabenstruktur (20) mit dem Isoliermaterial (16) derart konfiguriert ist, dass das Isoliermaterial eine Dicke e16 entlang der Querrichtung (y) derart aufweist, dass e15 < e16/3.

11. Verfahren nach einem der vorstehenden Ansprüche, das außerdem nach dem Entfernen der Opferschicht (15) und vor dem Füllen des Hohlraums (20) durch ein elektrisch leitfähiges Material ein konformes Abscheiden einer Schicht (51) aus einem zweiten dielektrischen Material auf den exponierten Wänden des Hohlraums (50) beispielsweise durch Gasphasenabscheiden (CVD) umfasst.

12. Verfahren nach dem vorstehenden Anspruch, wobei die Schicht (51) aus einem zweiten dielektrischen Material eine Dicke e51 aufweist, wobei die Opferbeschichtungsschicht (15) eine Dicke e15 aufweist, das elektrisch leitfähige Material eine Dicke e5 derart aufweist, dass e51 < e15/3 und e51 < e5/3 und bevorzugt derart, dass e51 < e15/4 und e51 < e5/4.

13. Verfahren nach einem der vorstehenden Ansprüche, wobei das Isoliermaterial (16) der Isoliergräben (2) auf Basis von SiO2 ausgewählt wird.

14. Verfahren nach einem der vorstehenden Ansprüche, wobei die Opferschicht (11) auf der Trägerschicht (10) durch Epitaxie gebildet wird, wobei die Opferschicht (11) beispielsweise auf SiGe basiert.

## Claims

1. Method for producing a back gate (5) under a semiconductive device (D1), said semiconductive device (D1) being formed on a semiconductive layer (12) of a stack successively comprising a support layer (10), a sacrificial layer (11) and the semiconductive layer (12), said method comprising:
• a formation of isolation trenches (2) around the semiconductive device (D1), said isolation trenches (2) passing through the superficial semiconductive layer (12) and the sacrificial layer (11), and extending to the support layer (10),
• a partial etching of the isolation trenches (2) so as to form an opening (40b) opening onto the sacrificial layer (11),
• a removal of the sacrificial layer (11) selectively at the semiconductive layer (12), at the support layer (10) and at the isolation trenches (2), so as to form a cavity (50) under the semiconductive device (D1),
• a filling of the cavity (50) with an electrically conductive material, so as to form the back gate (5) under the semiconductive device (D1),
the formation of the isolation trenches (2) comprises:
• a first etching configured to form at least one trench pattern (20) having a bottom (22) and flanks (21),
• a formation of a sacrificial coating layer (15) at least on the flanks (21) of the at least one trench pattern (20), in contact with the sacrificial layer (11) of the stack,
said method being **characterised in that** the formation of the isolation trenches (2) further comprises, after formation of the sacrificial coating layer (15):
• a filling of the at least one trench pattern (20) with an isolating material (16), configured such that said isolating material (16) extends at least to within the sacrificial layer (11) of the stack, and preferably to within the support layer (10) of the stack,
and **in that** the partial etching of the isolation trenches (2) comprises:
• a removal of the sacrificial coating layer (15) selectively at the isolating material (16).

2. Method according to the preceding claim, wherein the semiconductive device (D1) is a quantum device, and wherein the electrically conductive material is metal.

3. Method according to any one of the preceding claims, wherein the semiconductive device (D1) is adjacent to a second semiconductive device (D2) separated from the semiconductive device (D1) by an isolation trench (2) having a first flank on the side of the semiconductive device (D1) and a second flank on the side of the second semiconductive device (D2), said isolation trench (2) comprising a first sacrificial coating layer portion (15l) on the first flank and a second sacrificial coating layer portion (15l) on the second flank,
wherein the partial etching of said isolation trench (2) comprises a simultaneous removal of the first and second sacrificial coating layer portions (15l),
so as to form a first back gate (5) under the semiconductive device (D1) and a second back gate (5) under the second semiconductive device (D2).

4. Method according to any one of claims 1 to 2, wherein the semiconductive device (D1) is adjacent to a second semiconductive device (D2) separated from the semiconductive device (D1) by an isolation trench (2) having a first flank on the side of the semiconductive device (D1) and a second flank on the side of the second semiconductive device (D2), said isolation trench (2) comprising a first sacrificial coating layer portion (15l) on the first flank and a second sacrificial coating layer portion (15l) on the second flank,
wherein the partial etching of said isolation trench (2) comprises a removal of the first sacrificial coating layer portion (15l) only, without removal of the second sacrificial coating layer portion,
so as to form the back gate (5) only under the semiconductive device (D1), by preserving a sacrificial layer portion (11) under the second semiconductive device (D2).

5. Method according to any one of the preceding claims, wherein the formation of the sacrificial coating layer (15) is done by compatible deposition on the flanks (21) and the bottom (22) of the at least one trench pattern (20).

6. Method according to the preceding claim, wherein the removal of the sacrificial coating layer (15) is only partial and configured to preserve a portion (15b) of the sacrificial coating layer located on the bottom (22) of the at least one trench pattern (20).

7. Method according to any one of claims 1 to 4, wherein the formation of the sacrificial coating layer (15) comprises a compatible deposition on the flanks (21) and the bottom (22) of the at least one trench pattern (20), followed by an anisotropic etching configured to remove a portion (15b) of the sacrificial coating layer located on the bottom (22) of the at least one trench pattern (20), such that the sacrificial coating layer (15, 15l) only covers the flanks (21) of the at least one trench pattern (20), before filling the at least one trench pattern (20) with the isolating material (16).

8. Method according to the preceding claim, wherein the removal of the sacrificial coating layer (15, 15l) is total.

9. Method according to any one of the preceding claims, wherein the sacrificial coating layer (15) is chosen with the basis of a first dielectric material, for example, SiN or SiC.

10. Method according to any one of the preceding claims, wherein the formation of the sacrificial coating layer (15) is configured, such that the sacrificial coating layer (15) has a thickness e15 in a direction (y) transverse to the flanks (21) of the at least one trench pattern (20), and the filling of the at least one trench pattern (20) with the isolating material (16) is configured such that the isolating material has a thickness e16 in said transverse direction (y), such that e15 < e16/3.

11. Method according to any one of the preceding claims, further comprising, after removal of the sacrificial layer (15) and before filling the cavity (20) with an electrically conductive material, a compatible deposition of a layer (51) made of a second dielectric material on exposed walls of the cavity (50), for example, by chemical vapour deposition (CVD).

12. Method according to the preceding claim, wherein the layer (51) made of a second dielectric material has a thickness e51, the sacrificial coating layer (15) has a thickness e15, the electrically conductive material has a thickness e5, such that e51 < e15/3 and e51 < e5/3, and preferably such that e51 < e15/4 and e51 < e5/4.

13. Method according to any one of the preceding claims, wherein the isolating material (16) of the isolation trenches (2) is chosen with the basis of SiO₂.

14. Method according to any one of the preceding claims, wherein the sacrificial layer (11) is formed on the support layer (10) by epitaxy, said sacrificial layer (11) being, for example, SiGe-based.
